# EUROPEAN PATENT APPLICATION

(11) **EP 4 776 325 A1**
(43) Date of publication of application: **15.07.2026**
(21) Application number: 25151774.4
(22) Date of filing: 14.01.2025
(51) Int. Cl.: H01J 37/147, H01J 37/20, H01J 37/30

(54) **APPARATUS FOR POSITIONING CHARGED PARTICLE**

(71) Applicant: ASML Netherlands B.V., 5500 AH Veldhoven (NL)
(72) Inventor: BEUKMAN, Arjan, Johannes, Anton, 5500 AH Veldhoven (NL); MAHAJAN, Sunit Sondhi, 5500 AH Veldhoven (NL); WÖLTGENS, Pieter, Joseph, Marie, 5500 AH Veldhoven (NL)
(74) Representative: ASML Netherlands B.V.

(57) **Abstract**

An apparatus for positioning a charged particle relative to a target location of a substrate, the apparatus comprising: a positioning magnetic field generator configured to generate a positioning magnetic field such that the charged particle follows a curved trajectory within the positioning magnetic field; and a substrate support configured to rotate the substrate so as to control a velocity of the charged particle relative to the target location.

## Description

### FIELD

The present invention relates to an apparatus for positioning a charged particle, and a method for positioning a charged particle, more particularly relative to a target location of a substrate.

### BACKGROUND

It is desirable to be able to position a charged particle or ion with respect to a substrate. For example, ions may be implanted into a substrate. For example, a substrate may be doped with ions.

One application for placing atoms or ions is to build a qubit, for example for a quantum computer. To form one type of qubit, it is essential to position individual ions (in particular phosphorous ions) at specific locations, for example on a regular grid pattern.

Another application for positioning atoms/ions onto a substrate is for local film growth. For example, atomic layer deposition or chemical vapour deposition may be performed using atoms or molecules.

Another application is for etching, or removing portions of the substrate using the incident ion.

It is desirable to position ions accurately relative to the substrate to accomplish these ends. In order to position atoms more accurately, atoms may be cooled and subsequently deposited onto the substrate. By cooling the atoms, their motion energy is reduced such that their position may be controlled more accurately.

However, conventional ion implantation is stochastic, such that the final position of the ion is difficult to control. Furthermore, atom-cooling techniques to slow the ions may require cooling lasers that are specific for the atoms or ion species used.

It is desirable to further increase the accuracy of placing ions on a substrate. It is also desirable to increase the variety of ion species that can be placed.

### SUMMARY OF THE INVENTION

According to aspects of the present invention there is provided an apparatus for positioning a charged particle relative to a target location of a substrate, the apparatus comprising:
a positioning magnetic field generator configured to generate a positioning magnetic field such that the charged particle follows a curved trajectory within the positioning magnetic field; and
a substrate support configured to rotate the substrate so as to control a velocity of the charged particle relative to the target location.

According to another aspect of the present invention there is provided a method for positioning a charged particle relative to a target location of a substrate, the method comprising:
generating a positioning magnetic field such that the charged particle follows a curved trajectory within the positioning magnetic field; and
rotating the substrate so as to control a velocity of the charged particle relative to the target location.

### BRIEF DESCRIPTION OF THE DRAWINGS

Embodiments of the invention will now be described, by way of example only, with reference to the accompanying schematic drawings, in which corresponding reference symbols indicate corresponding parts.
Figure 1 schematically depicts a plan view of an apparatus for positioning a charged particle.
Figure 2 schematically depicts a side view of the apparatus shown in Figure 1.
Figure 3 schematically depicts arrangement of electrodes of the apparatus shown in Figure 1.
Figure 4 schematically depicts an alternative arrangement of electrodes for the apparatus shown in Figure 1.
Figure 5 schematically depicts the apparatus shown in Figure 1 further comprising additional components.
Figure 6 schematically depicts a velocity selector of the apparatus shown in Figure 5, for example.

### DETAILED DESCRIPTION

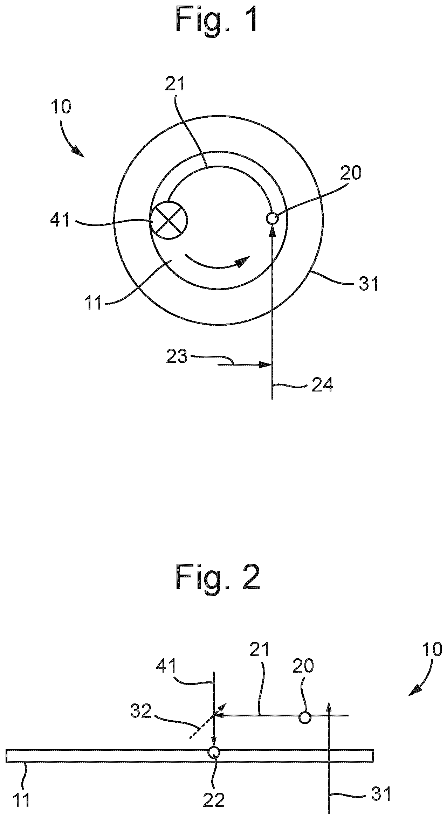

Figure 1 schematically depicts an apparatus 10. Figure 1 is a plan view of the apparatus 10. Figure 2 is a schematic side view of the apparatus 10 shown in Figure 1.

The apparatus 10 is for positioning a charged particle 20. The invention is described primarily with reference to the charged particle being an ion. Where reference is made to an ion, it should be understood that the ion may be any charged particle or charged molecule. In a further embodiment, the charged particle is an electron. The charged particle or charged molecule may be positively charged or negatively charged. The invention is described primarily in the context of the positively charged ion.

More particularly, the apparatus 10 may be for positioning a charged particle 20 relative to a target location 22 of a substrate 11. The target location 22 is a target location of the charged particle 20. The substrate 11 may be planar. The substrate 11 may be discoid, for example. The target location 22 may be a location on the substrate 11 onto which it is desired to place the charged particle 20. For example, the target location 22 may be referred to as a deposition location when it is desirable to deposit the charged particle 20 onto the substrate 11. The target location 22 may be a location on the substrate 11 where a material is removed by the charged particle, e.g. via an etching process. The target location 22 may be a location on the substrate 11 where a property of a material is changed by the charged particle, e.g. via a doping process. In an embodiment the target location 22 is located at or near a major surface of the substrate 11.

The term "substrate" as employed in this text may be broadly interpreted as referring to an object on which a pattern may be created or which may be subject of assessment. Examples include a semiconductor substrate and a substrate made of other material (e.g. a glass substrate). The semiconductor substrate may be a wafer, such as a silicon wafer, for example. Alternatively or additionally, the substrate may include other semiconductor materials such as germanium (Ge) or carbon (C). In some embodiments, the semiconductor substrate is made of a compound semiconductor such as III-V compound semiconductors, II-V compound semiconductors, and/or any suitable integration of Group IV materials. In some embodiments, the substrate may be a silicon-on-insulator (SOI) or a germanium-on-insulator (GOI) substrate. The "substrate" may a "patterning device", which may be broadly interpreted as referring to an object that can be used to endow an incoming radiation with a patterned cross-section, for the purpose of creating a pattern in a target portion of a substrate. Besides classic mask or reticle (transmissive or reflective, binary, phase-shifting, hybrid, etc.), examples of other such patterning devices include a programmable mirror array, a programmable LCD array, and a nanoimprint template.

In an embodiment the apparatus 10 comprises a positioning magnetic field generator configured to generate a positioning magnetic field 31. In an embodiment the positioning magnetic field 31 is substantially steady. The positioning magnetic field 31 is a magnetic field 31 for positioning the charged particle 20. More particularly, the positioning magnetic field 31 may be for contributing to positioning of the charged particle 20 relative to the target location 22 of the substrate 11. The positioning magnetic field generator comprises one or more coils for generating the positioning magnetic field 31.

As shown in Figure 1, in an embodiment the positioning magnetic field 31 is generated such that the charged particle 20 follows a curved trajectory 21 within the positioning magnetic field 31. In an embodiment the curved trajectory 21 is substantially parallel to the substrate 11. The curved trajectory 21 is distanced from the substrate 11. In other words, the curved trajectory 21 is not coincident with the substrate 11. The positioning magnetic field 31 may be present in a region faced by the target surface of the substrate 11. The target surface of the substrate 11 may be the surface of the substrate 11 that comprises the target location 22. The curved trajectory 21 is shown in Figure 1.

As shown in Figure 2, in an embodiment the substrate 11 is substantially planar. The substrate 11 may be plate shaped. As shown in Figure 1, in an embodiment the substrate 11 is substantially circular. However, alternative shapes of substrate may be used. For example, the substrate 11 may be rectangular or otherwise polygonal.

As shown in Figure 1, in an embodiment the curved trajectory followed by the charged particle 20 as a result of the positioning magnetic field 31 may be at least partly parallel to a plane of the substrate 11. As shown in Figure 2, in an embodiment the positioning magnetic field 31 is at least partly normal to the plane of the substrate 11.

In an embodiment the apparatus 10 comprises a substrate support. The substrate support is configured to support the substrate 11. An embodiment of the substrate support is configured to rotate the substrate 11 so as to control (e.g. lower) a velocity of the charged particle 20 relative to the target location 22. The velocity that is controlled (e.g. lowered) may be a tangential velocity. In an embodiment the substrate 11 is rotated within the positioning magnetic field 31. In an embodiment the substrate 11 is rotated substantially coaxially with the curved trajectory 21. The charged particle 20 may follow the curved trajectory 21 independently of the rotation of the substrate 11. In Figure 1, the rotation of the substrate 11 is indicated by the curved arrow of the substrate 11. As shown in Figure 1, in an embodiment the substrate 11 is rotated in the same rotational direction as the curved trajectory 21 of the charged particle 20. By rotating the substrate 11, the velocity between the charged particle 20 and the target location 22 may be reduced.

As shown in Figure 1, in an embodiment the curved trajectory 21 is substantially circular in shape. That is, the curved trajectory 21 may form an arc of a circle. The curved trajectory 21 may form the arc of a circle centred on the rotational axis of the substrate 11. If the angular speed of the charged particle 20 along the curved trajectory 21 matches the angular speed of the rotating substrate 11, then the charged particle 20 may be substantially stationary with respect to the target location 22. However, it is not essential for the charged particle 20 to be completely stationary with respect to the target location 22. In an embodiment the relative angular speed between the charged particle 20 and the target location 22 is non-zero, which remains lower than the angular speed of the charged particle 20 relative to a stationary object.

By reducing the relative speed between the target location 22 and the charged particle 20, the charged particle 20 may be positioned more accurately onto the target location 22. The control over the placement of the charged particle 20 onto the target location 22 may be increased. An embodiment of the invention is expected to increase the accuracy of placement of a charged particle 20 relative to the target location 22.

In particular, conventional ion implantation has been stochastic. The placement accuracy has been low because after an ion (e.g. a phosphorous ion) collides into the substrate, the ion may continue to move relative to the location at which the ion entered the substrate, until the ion loses sufficient energy to stop relative to the substrate. The movement of the ion following impact of the ion into the substrate is uncontrolled. By reducing the relative speed between the charged particle 20 and the target location 22, such uncontrolled motion of the charged particle 20 may be reduced.

An embodiment of the invention is expected to increase the variety of different ions that can be positioned accurately relative to the target location 22 of the substrate 11. In particular, the charged particle 20 may be positioned without requiring atom-cooling techniques. Such atom-cooling techniques may require the use of cooling lasers that are specific for the ion species used. In contrast, the embodiment of the invention is expected to achieve accurate positioning of the charged particle 20 relative to the target location 22 over a broad range of different ion species. The embodiment of any ion species may be positioned according to the present invention.

In an embodiment the substrate support is configured to rotate the substrate 11 such that the substrate 11 has substantially the same angular frequency (i.e. oscillation frequency) as the trajectory 21 of the charged particle 20. In an embodiment the curved trajectory 21 of the charged particle 20 and the substrate 11 are in substantially parallel planes. For example, once the charged particle 20 has substantially the same angular position as the target location 22, then the substrate 11 may be rotated so as to match the angular frequency of the charged particle 20. The radial position of the charged particle 20 may then be controlled so as to move the charged particle 20 to the target location 22. By rotating the substrate 11 at substantially the same frequency as the charged particle 20, any motion of the charged particle 20 following impact into the substrate 11 may be reduced and/or better controlled.

However, it is not essential for the substrate support to rotate the substrate 11 to have substantially the same angular frequency as the charged particle 20. For example, when the angular position of the charged particle 20 is different from the angular position of the target location, then it may be desirable to have a difference between the angular frequency of the charged particle 20 and the angular frequency of the substrate 11. Such a difference may allow the angular position of the charged particle 20 relative to the substrate 11 to be changed. An embodiment of the invention is expected to allow the angular position of the charged particle 20 to be controlled so as to match the angular position of the target location 22.

In an embodiment the substrate support is configured to rotate the substrate 11 such that the charged particle 20 is substantially stationary relative to the target location 22. For example, when the charged particle 20 is located close to (e.g. above) the target location 22 (in the orientation shown in Figure 2), then the rotation of the substrate 11 may be controlled so that the charged particle 20 is substantially stationary relative to the target location 22. The extent of movement of the charged particle 20 after impact into the substrate 11 may be reduced.

During positioning of the charged particle 20 relative to the target location 22, the rotation of the substrate 11 and/or the curved trajectory 21 of the charged particle 20 may be controlled such that the charged particle 20 moves to the target location 22.

As shown in Figure 2, in an embodiment the positioning magnetic field 31 is substantially perpendicular to the substrate 11. That is, the magnetic flux may be substantially normal to a plane of the substrate 11. The positioning magnetic field generator may be configured to generate the positioning magnetic field 31 substantially perpendicularly to the substrate 11. By providing that the positioning magnetic field 31 is substantially normal to the substrate 11, the positioning magnetic field 31 acts to cause the charged particle 20 entering the positioning magnetic field 31 to follow the curved trajectory 20.

During use of the apparatus 10, a charged particle 20 enters the positioning magnetic field 31. In an embodiment the positioning magnetic field 31 is a static magnetic field. As a result of the charged particle 20 entering the positioning magnetic field 31, the charged particle 20 follows a circular trajectory. In an embodiment the charged particle 20 substantially maintains its initial velocity (i.e. the velocity of the charged particle 20 before the charged particle 20 entered into the positioning magnetic field 31). A constant magnetic field does no work on a charged particle. Therefore, the charged particle 20 substantially maintains its speed from immediately before entering the positioning magnetic field 31. Of course, when the magnetic field is varied (e.g. when the positioning magnetic field 31 is varied), then the speed and trajectory of the charged particle 20 may be varied away from the circular curved trajectory 21.

It is not essential for the positioning magnetic field 31 to be perfectly perpendicular to the substrate 11. For example, the positioning magnetic field 31 may comprise a lateral component. The lateral component is a component of the positioning magnetic field 31 that is in a lateral direction. A lateral direction is a direction parallel to the plane of the substrate 11. For example, such a lateral component may be provided so as to controllably curve the charged particle 20 towards or away from the substrate 11. This may help to control landing of the charged particle 20 onto the target position 22.

In an embodiment the positioning magnetic field 31 is controllable so as to control a position of the charged particle 20 relative to the target location 22. For example, the strength of the positioning magnetic field 31 may be controlled. In an embodiment the apparatus 10 comprises a controller. The controller may be configured to control the positioning magnetic field generator so as to control the positioning magnetic field 31. In an embodiment the controller is configured to control the substrate support so as to control rotation of the substrate 11.

In an embodiment the controller is configured to lower the positioning magnetic field 31. By lowering the positioning magnetic field 31, centripetal acceleration of the charged particle 20 may be changed, thereby causing the charged particle 20 to move outwards relative to the rotational axis of the substrate 11. The radial position of the charged particle 20 may be controlled by controlling the positioning magnetic field 31. In an embodiment the controller is configured to increase the strength of the positioning magnetic field 31. By raising the positioning magnetic field 31, the centripetal acceleration of the charged particle 20 may be changed such that the charged particle 20 moves radially inwards relative to the rotational axis of the substrate 11. An embodiment of the invention is expected to increase the accuracy of positioning of the charged particle 20 relative to the target location 22.

The controlling magnetic field may vary in an alternating manner to move the charged particle laterally due to the induced electric fields.

However, it is not essential for the positioning magnetic field 31 to be controllable so as to control the position of the charged particle 20 relative to the target location 22. Additionally or alternatively electric field may be controlled so as to control the position of the charged particle 20 relative to the target location 22.

In an embodiment the rotation of the substrate support is controllable so as to control a position of the charged particle 20 relative to the target location 22. For example, by increasing the (or decreasing) the rotation of the substrate support away from the rotational speed of the charged particle 20, the angular position of the charged particle 20 relative to the target location 22 may be controlled.

As shown in Figure 1, in an embodiment the charged particle 20 has an initial trajectory 24 before the charged particle 20 enters the positioning magnetic field 31. In an embodiment the initial trajectory 24 is substantially straight. As shown in Figure 1, in an embodiment the initial trajectory 24 is provided at a radius 23 relative to the rotational axis of the substrate support.

When the charged particle 20 enters the positional magnetic field 31, the initial trajectory 24 of the charged particle 20 is converted into the curved trajectory 21. The curved trajectory 21 may be circular. By rotating the substrate 11 underneath (in the orientation shown in Figure 2) the charged particle 20, the velocity of the charged particle 20 can be matched with the velocity of the substrate 11. In the frame of reference of the charged particle, the substrate 11 is then substantially stationary.

In the orientation shown in Figure 2, the charged particle 20 is above the substrate 11. However, it is not essential for the charged particle 20 to be vertically above the substrate 11. The apparatus 10 may be oriented in a different way, for example such that the charged particle 20 is to one side of the substrate 11, or is below the substrate 11.

As shown in Figure 1, in an embodiment the apparatus 10 is configured to provide a placement electric field 31. In the arrangement shown in Figure 1, the placement electric field 41 is substantially normal to the plane of the substrate 11. The placement electric field 41 may be substantially parallel to the positioning magnetic field 31.

By providing the placement electric field 41, the charged particle 20 can be guided to land onto the substrate 11. The charged particle 20 may interact with the placement electric field 41 so as to move towards the substrate 11. For example, once the position of the charged particle 20 matches the position of the target location 22 parallel to the plane of the substrate 11, then the placement electric field 41 may cause the charged particle 20 to move onto the target location 22. In other words, the charged particle 20 may hover above the same point on the substrate 11 (e.g. above the target location 22). As a result, the landing of the charged particle onto the substrate 11 can occur with a relatively small landing energy. The stochastic nature of the final position of the charged particle 20 may be reduced.

In an embodiment the controller is configured to control the placement electric field 41 so as to control landing of the charged particle 20 onto the substrate 11. For example, the placement electric field 41 may be switched off while the position of the charged particle 20 is being controlled relative to the target location 22 parallel to the plane of the substrate 11. Once the charged particle 20 is above the target location 22, then the controller may switch on the placement electric field 41. The charged particle 20 may then land on the target location 22.

In an embodiment the apparatus 10 comprises a placement device configured to place the charged particle 20 onto the target location 22. For example, in an embodiment the placement device comprises placement electrodes configured to generate the placement electric field 41 that is controllable so as to move the charged particle 20 onto the target location 22.

Additionally or alternatively, the placement device may comprise a placement magnetic field generator. The placement magnetic field generator may be configured to generate a placement magnetic field 32. Figure 2 schematically depicts the orientation of the placement magnetic field 32. In an embodiment the placement magnetic field is substantially lateral with respect to the claim of the substrate 11.

In an embodiment the placement magnetic field 32 is controllable so as to move the charged particle 20 onto the target location 22. For example, the placement magnetic field 32 may be configured such that interaction of the charged particle 20 with the placement magnetic field 32 causes a force on the charged particle 20 in a direction away from the substrate 11. Simultaneously, the placement electric field 41 may induce a greater force on the charged particle 20 towards the substrate 11. By providing the placement magnetic field 32, the landing of the charged particle 20 onto the substrate 11 may be softer (i.e. at lower energy).

In an alternative arrangement, the placement magnetic field 32 may be controlled such that interaction of the charged particle 20 with the placement magnetic field 32 induces a force on the charged particle 20 towards the substrate 11. The placement magnetic field 32 may cause the charged particle 20 to land onto the target location 22. In an embodiment the placement electric field 41 may be omitted.

Additionally or alternatively, in an embodiment the placement device comprises a substrate actuator. The substrate actuator is configured to actuate the substrate 11 towards the charged particle 20. For example, in the orientation shown in Figure 2, the substrate actuator may be configured to raise the substrate 11 upwards so as to induce contact between the substrate 11 and the charged particle 20. In an embodiment the controller is configured to control the substrate actuator so as to control the relative speed of the substrate 11 and the charged particle 20 in a direction substantially normal to the plane of the substrate 11.

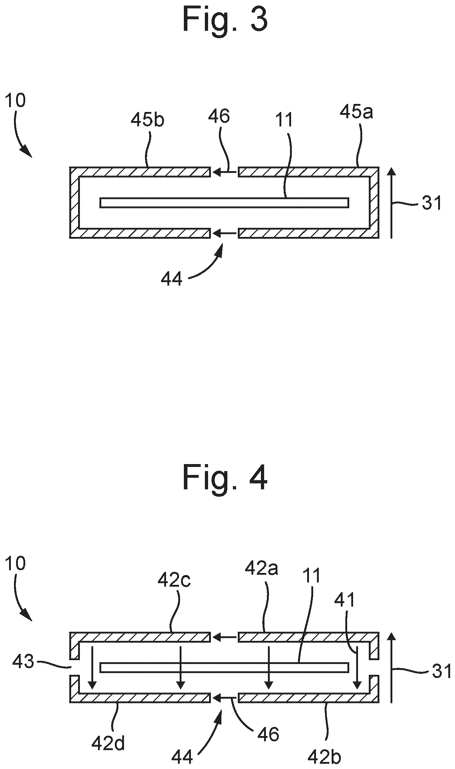

Figure 3 schematically depicts electrodes of the apparatus 10 shown Figure 1. Figure 3 schematically depicts a side on view of the electrodes. As shown in Figure 3, in an embodiment the apparatus 10 comprises electrodes located around the substrate 11.

As shown in Figure 3, in an embodiment the apparatus 10 comprises positioning electrodes 45a, 45b. The positioning electrodes 45a, 45b are configured to generate a positioning electric field 46. In an embodiment the positioning electric field 46 is controllable so as to control a position of the charged particle 20 relative to the target location 22. In an embodiment the positioning electric field 46 is configured to accelerate or decelerate the charged particle 20 as the charged particle 20 follows the curved trajectory 21. By accelerating or decelerating the charged particle 20, the position of the charged particle 20 parallel to the substrate 11 may be controlled.

In an embodiment each of the positioning electrodes 45a, 45b is electrically connected to a power supply. In an embodiment separate power supplies are provided for the positioning electrodes 45a, 45b. In an alternative embodiment a single power source is provided to be electrically connected to the positioning electrodes 45a, 45b. In an embodiment the power supply comprises an oscillator configured to supply oscillating signals to the positioning electrodes 45a, 45b. In an embodiment the positioning electrodes 45a, 45b at least partly enclose the substrate 11. In an embodiment the positioning electrodes 45a, 45b are D-shaped.

In an embodiment the potentials of the positioning electrodes 45a, 45b are controlled such that there is a potential difference between the positioning electrodes 45a, 45b. When the charged particle 20 passes near a gap 44 separating the positioning electrodes 45a, 45b, the charged particle 20 may be accelerated or decelerated by the positioning electric field 46. By controlling the timing at which the plurality of the positioning electric field 46 switches, the charged particle 20 may be repeatedly accelerated or decelerated as the charged particle 20 performs each half turn around the curved trajectory 21.

In general, when the charged particle 20 is accelerated, the charged particle 20 may move radially outwards relative to the rotational axis of the substrate 11. When the charged particle 20 is decelerated, the radial position of the charged particle 20 may be moved towards the rotational axis of the substrate 11.

As shown in Figure 3, in an embodiment the positioning electric field 46 is angled (e.g. substantially perpendicular to) the positioning magnetic field 31.

Although not shown in Figure 3, in an embodiment additional electrodes may be provided so as to generate the placement electric field 41 for placing the charged particle 20 onto the substrate 11. Alternatively, other forms of placement device may be used to place the charged particle 20 onto the substrate 11 as described elsewhere.

In an embodiment the positioning electric field 46 is controllable to accelerate a charged particle 20 to move laterally beyond the substrate 11. By accelerating a charged particle 20 to move laterally beyond the substrate 20, the charged particle 20 may be moved to a position at which it can no longer be landed onto the substrate 11. It may be desirable, for example, so as to control the number of charged particles 20 that are landed onto the substrate 11. An embodiment of the invention is expected to increase control over the number of charged particles 20 landed onto a substrate 11.

In an embodiment the apparatus 10 is configured to position a single charged particle 20 relative to the target location 22 of the substrate 11. Alternatively, the apparatus 10 may be used so as to land two, three, four or more than four charged particles 20 onto respective target locations 22 of the substrate 11.

During use of the apparatus 10, it may be that two or more charged particles 20 are located undesirably close to each other. By controlling the positioning electric field 46, the spacing between charged particles 20 within a group of charged particles 20 may be adjusted. For example, the positioning electric field 46 may be controlled to be different for one charged particle 20 passing near the gaps 44 between the positioning electrodes 45a, 45b compared to for another charged particle 20 passing near the gaps 44. The positions of charged particles 20 within a group of charged particles 20 may be controlled relative to each other.

Figure 4 schematically depicts an alternative arrangement of electrodes of the apparatus 10 of Figure 1. Figure 4 schematically depicts a side on view of the electrodes located around the substrate 11.

As shown in Figure 4, a first pair of positioning electrodes 42a, 42c may be provided. By controlling a potential difference between the first pair of positioning electrodes 42a, 42c, positioning electric field 46 between the first pair of positioning electrodes 42a, 42c may be generated. The positioning electric field 46 may be controlled as described elsewhere so as to control the position of each charged particle 20 in directions parallel to the plane of the substrate 11.

The electrodes shown in Figure 4 may additionally be used so as to provide the placement electric field 41 for placing the charged particle 20 onto the target location 22. For example, the apparatus 10 comprises at least one placement electrode 42b, 42d such that the substrate 11 is located between the positioning electrodes 42a, 42c and the at least one placement electrodes 42b, 42d. The placement electric field 41 is generated between the positioning electrodes 42a, 42c and the at least one placement electrode 42b, 42d. In an embodiment the placement electric field 41 is controllable so as to move the charged particle 20 onto the target location 22. The electrodes 42a, 42b, 42c, 42d are configured to function so as to generate both a positioning electric field 46 and a placement electric field 41. A positioning electric field 46 is for positioning the particles 20 to the plane of the substrate 11. The placement electric field 41 is for landing the charged particle 20 onto the substrate 11.

In an embodiment the placement electrodes 42b, 42d function as a second pair of positioning electrodes. In an embodiment the controller is configured to control the potential difference between the first pair of positioning electrodes 42a, 42c to be similar or the same as the potential difference between the pair of placement electrodes 42b, 42d so as to provide consistent positioning electric field 46 on either side of the substrate 11.

However, it is not essential for the electrodes 42, 42b, 42c, 42d to generate both the positioning electric field 46 and the placement electric field 41. As explained elsewhere, the charged particle 20 may be placed by means other than a placement electric field 41. The lateral position of the charged particles 20 may be controlled by means other than the positioning electric field 46.

As shown in Figure 4, in an embodiment the placement electrodes 42b, 42d substantially overlap respective positioning electrodes 42a, 42c when viewed in a direction perpendicularly to the substrate 11. This can help to provide a substantially uniform placement electric field 41 extending substantially perpendicular to the plane of the substrate 11.

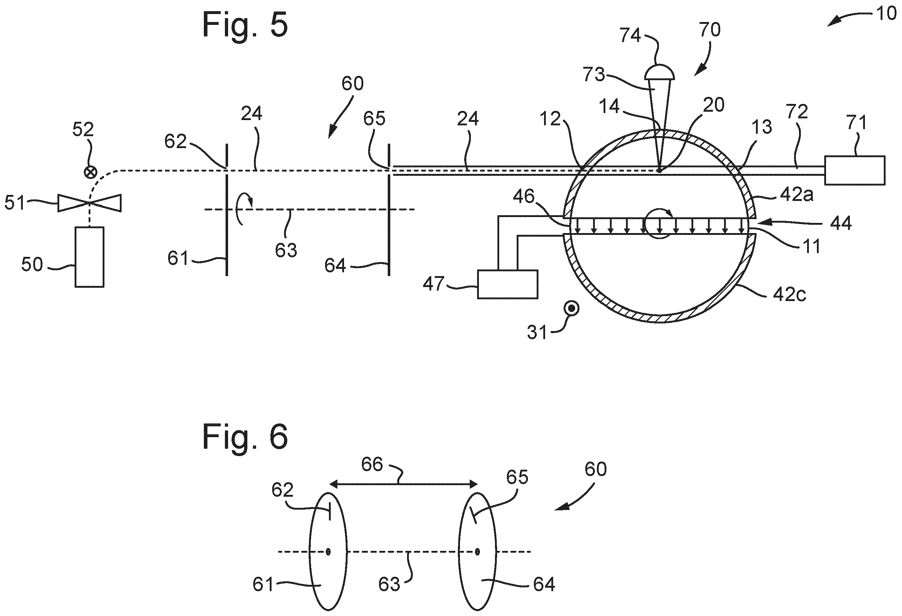

Figure 5 schematically depicts an apparatus 10 for positioning a charged particle 20 relative to a target location 22 of a substrate 11. As shown in Figure 5, in an embodiment the apparatus 10 comprises a charged particle source 50. The charged particle source 50 is configured to generate charged particles 20 to be entered into the positioning magnetic field 31. In an embodiment the charged particle source 50 comprises a thermal source. The charged particle source 50 may comprise an atom oven, for example. In an embodiment charged particle source 50 is configured to heat a body of a material so as to generate a flux of atoms emitted by the charged particle source 50. The charged particle source 50 may be configured to thermally evaporate a material so as to emit atoms of a particular material.

As shown in Figure 5, in an embodiment the charged particle source 50 comprises an ioniser 51. The ioniser 51 is configured to ionise a particle to form the charged particle. The thermal source may be configured to generate a flux of particles. However, the particles may be neutral. The ioniser 51 is configured to ionise the particles to form the charged particles 20.

In an embodiment the ioniser comprises a laser source. The laser source is configured to emit a laser to the flux of particles so as to ionise the particles. Additionally or alternatively, the ioniser 51 comprises a radio frequency (RF) field generator. The RF field generator is configured to generate an RF field of sufficient energy to ionise the particles into the charged particles 20. Additionally or alternatively, the ioniser 51 comprises a charged particle beam generator such as an electron beam generator. By emitting a beam of charged particles towards the flux of particles from the thermal source, charged particles 20 may be formed from the particles. The charged particle beam generator may be an electron beam generator or an ion beam generator, for example.

As shown in Figure 5, in an embodiment the apparatus comprises a charged particle selector 52. For example, the charged particle selector 52 may comprise a magnetic field generator configured to generate a magnetic field. Interaction between the charged particles 20 and the magnetic field causes the charged particles 20 to curve and subsequently follow their initial trajectory 24. The initial trajectory 24 may be substantially straight. Neutral particles (i.e. particles emitted from the thermal source that have not been ionised) are not curved by the interaction with the magnetic field and therefore do not follow the initial trajectory 24 of the charged particles 20.

As shown in Figure 5, in an embodiment the apparatus 10 comprises a velocity selector 60. In an embodiment the velocity selector 60 is configured to filter charged particles 20 for charged particles 20 having a velocity within a particular range. In the arrangement shown in Figure 5, the velocity selector 60 comprises a double chopper, explained in more detail with reference to Figure 6. However, it is not essential for the velocity selector 60 to comprise a double chopper 60. In an alternative arrangement, the velocity selector 60 comprises one or more of a Wien filter a filtering magnetic field generator configured to generate a filtering magnetic field, and a calutron. A filtering magnetic field generator may generate a filtering magnetic field that filters by curving the trajectory of charged particles 20 by an amount that depends on the velocity of the charged particles 20. Only charged particles 20 that have a velocity within a particular range follow a trajectory that leads to the charged particles 20 entering into the positioning magnetic field 31. Charged particles 20 having different velocities do not enter the positioning magnetic field 31 and are therefore filtered out.

As shown in Figure 5, in an embodiment the charged particles 20 enter into the positioning magnetic field 31 at an entry point 12. The entry point 12 may correspond to an opening in one or more of the electrodes of the apparatus 10.

As shown in Figure 5, in an embodiment the apparatus 10 comprises a detector 74. The detector 74 may be configured to detect a location of the charged particle 20 relative to the target location 22. In an embodiment the detector 74 is configured to output a detection signal to the controller. In an embodiment the controller is configured to control positioning of the charged particle 20 based on the back via the detection signal from the detector 70.

As shown in Figure 5, in an embodiment the apparatus 10 comprises a light source 71. The light source 71 may be, for example, a laser. The laser may be at resonance with an energy level of the ion. In an embodiment the light source 71 is configured to direct light towards the charged particle 20 in the positioning magnetic field 31. The light may be scattered by the charged particle 20. Some of the scattered light may reach the detector 74.

As shown in Figure 5, in an embodiment the light 72 output by the light source 71 enters the positioning magnetic field 31 via a light entry point 13. The light entry point 13 may correspond to an opening in one or more of the electrodes of the apparatus 10.

As shown in Figure 5, in an embodiment the scattered light 73 may exit the electrodes at a light exit point 14. The light exit point 14 may correspond to an opening in one or more of the electrodes of the apparatus 10. The scattered light 73 is detected by the detector 74 so as to monitor the position of the charged particle 20.

Figure 6 schematically depicts a velocity selector 60. The velocity selector 60 shown in Figure 5 is a double chopper. A double chopper comprises two separated rotating slotted discs configured to select certain ion velocities through them. The velocity of atoms can be narrowly selected using two choppers 61, 64. In an embodiment, each chopper 61, 64 comprises a disc with an aperture 62, 65. For example, a first chopper 61 comprises a first aperture 62. A second chopper 64 comprises a second aperture 65.

In an embodiment, each chopper 61, 64 is configured to rotate about a rotational axis 63. In an embodiment both choppers 61, 64 rotate about the substantially the same rotational axis 63.

In an embodiment the spacing 66 between the choppers 61, 64 if known. By controlling the rotational speed of the choppers 61, 64, the charged particles 20 can be selected so as to select only charged particles 20 having a velocity within a particular range.

Further embodiments are disclosed in the subsequent numbered clauses:
1. An apparatus for positioning a charged particle relative to a target location of a substrate, the apparatus comprising:
   a positioning magnetic field generator configured to generate a positioning magnetic field such that the charged particle follows a curved trajectory within the positioning magnetic field; and
   a substrate support configured to rotate the substrate so as to control a velocity of the charged particle relative to the target location.
2. The apparatus of clause 1, wherein the substrate support configured to rotate the substrate so as to lower the velocity of the charged particle relative to the target location.
3. The apparatus of clause 1 or 2, wherein the substrate support is configured to rotate the substrate such that the substrate has substantially the same angular frequency as the curved trajectory of the charged particle.
4. The apparatus of any preceding clause, wherein the substrate support is configured to rotate the substrate such that the charged particle is substantially stationary relative to the target location.
5. The apparatus of any preceding clause, wherein the positioning magnetic field generator is configured to generate the positioning magnetic field substantially perpendicularly to the substrate.
6. The apparatus of any preceding clause, wherein the positioning magnetic field is controllable so as to control a position of the charged particle relative to the target location.
7. The apparatus of any preceding clause, wherein rotation of the substrate support is controllable so as to control a position of the charged particle relative to the target location.
8. The apparatus of any preceding clause comprising:
   positioning electrodes configured to generate a positioning electric field that is controllable so as to control a position of the charged particle relative to the target location.
9. The apparatus of clause 8, wherein the positioning electric field is controllable to accelerate a charged particle to move laterally beyond the substrate.
10. The apparatus of clause 8 or 9, wherein the electrodes are substantially D-shaped.
11. The apparatus of any of clauses 8-10 comprising:
   at least one placement electrode located such that the substrate is between the positioning electrodes and the at least one placement electrode so as to generate a placement electric field between the positioning electrodes and the at least one placement electrode, wherein the placement electric field is controllable so as to move the charged particle onto the target location.
12. The apparatus of clause 11 comprising placement electrodes substantially overlapping respective positioning electrodes when viewed in a direction perpendicularly to the substrate.
13. The apparatus of any preceding clause comprising:
   a placement device configured to place the charged particle onto the target location.
14. The apparatus of clause 13, wherein the placement device comprises:
   placement electrodes configured to generate a placement electric field that is controllable so as to move the charged particle onto the target location.
15. The apparatus of clause 13 or 14, wherein the placement device comprises:
   a placement magnetic field generator configured to generate a placement magnetic field that is controllable so as to move the charged particle onto the target location.
16. The apparatus of any of clauses 13-15, wherein the placement device comprises a substrate actuator configured to actuate the substrate towards the charged particle.
17. The apparatus of any preceding clause comprising:
   a charged particle source configured to generate charged particles to be entered into the magnetic field.
18. The apparatus of clause 17, wherein the charged particle source comprises an ioniser configured to ionise a particle to form the charged particle.
19. The apparatus of clause 18, wherein the ioniser comprises at least one of a laser source, a radio frequency field generator, and a charged particle beam generator.
20. The apparatus of any preceding clause comprising:
   a velocity selector configured to select charged particles for charged particles having a velocity within a particular range.
21. The apparatus of clause 20, wherein the velocity selector comprises at least one of a double chopper, a Wien filter, a filtering magnetic field generator configured to generate a filtering magnetic field, and a calutron.
22. The apparatus of any preceding clause comprising:
   a detector configured to detect a location of the charged particle relative to the target location.
23. The apparatus of any preceding clause comprising:
   a vacuum chamber configured to provide a vacuum in which the charged particle and the substrate are located.
24. A method for positioning a charged particle relative to a target location on a substrate, the method comprising:
   generating a positioning magnetic field such that the charged particle follows a curved trajectory within the positioning magnetic field; and
   rotating the substrate so as to control a velocity of the charged particle relative to the target location.

## Claims

1. An apparatus for positioning a charged particle relative to a target location of a substrate, the apparatus comprising:
a positioning magnetic field generator configured to generate a positioning magnetic field such that the charged particle follows a curved trajectory within the positioning magnetic field; and
a substrate support configured to rotate the substrate so as to control a velocity of the charged particle relative to the target location.

2. The apparatus of claim 1, wherein the substrate support configured to rotate the substrate so as to lower the velocity of the charged particle relative to the target location.

3. The apparatus of claim 1 or 2, wherein the substrate support is configured to rotate the substrate such that the substrate has substantially the same angular frequency as the curved trajectory of the charged particle.

4. The apparatus of any preceding claim, wherein the substrate support is configured to rotate the substrate such that the charged particle is substantially stationary relative to the target location.

5. The apparatus of any preceding claim, wherein the positioning magnetic field generator is configured to generate the positioning magnetic field substantially perpendicularly to the substrate.

6. The apparatus of any preceding claim, wherein the positioning magnetic field is controllable so as to control a position of the charged particle relative to the target location.

7. The apparatus of any preceding claim comprising:
positioning electrodes configured to generate a positioning electric field that is controllable so as to control a position of the charged particle relative to the target location.

8. The apparatus of claim 7, wherein the positioning electric field is controllable to accelerate a charged particle to move laterally beyond the substrate.

9. The apparatus of claim 7 or 8, wherein the electrodes are substantially D-shaped.

10. The apparatus of any of claims 7-9 comprising:
at least one placement electrode located such that the substrate is between the positioning electrodes and the at least one placement electrode so as to generate a placement electric field between the positioning electrodes and the at least one placement electrode, wherein the placement electric field is controllable so as to move the charged particle onto the target location.

11. The apparatus of any preceding claim comprising:
a placement device configured to place the charged particle onto the target location.

12. The apparatus of claim 11, wherein the placement device comprises:
placement electrodes configured to generate a placement electric field that is controllable so as to move the charged particle onto the target location.

13. The apparatus of claim 11 or 12, wherein the placement device comprises:
a placement magnetic field generator configured to generate a placement magnetic field that is controllable so as to move the charged particle onto the target location.

14. The apparatus of any of claims 11-13, wherein the placement device comprises a substrate actuator configured to actuate the substrate towards the charged particle.

15. A method for positioning a charged particle relative to a target location on a substrate, the method comprising:
generating a positioning magnetic field such that the charged particle follows a curved trajectory within the positioning magnetic field; and
rotating the substrate so as to control a velocity of the charged particle relative to the target location.
